# FASCICULE DE BREVET EUROPEEN

(11) **EP 1 397 813 B1**
(45) Date de publication et mention de la délivrance du brevet: **04.06.2008**
(21) Numéro de dépôt: 02740845.9
(22) Date de dépôt: 31.05.2002
(51) Int. Cl.: G21K 1/06, G02B 5/18

(54) **COMPOSANT OPTIQUE HYBRIDE POUR APPLICATIONS RAYONS X, ET PROCEDE ASSOCIE**
HYBRIDES OPTISCHES ELEMENT FÜR RÖNTGENSTRAHL-ANWENDUNGEN UND ZUGEHÖRIGES VERFAHREN
HYBRID OPTICAL COMPONENT FOR X RAY APPLICATIONS AND METHOD ASSOCIATED THEREWITH

(30) Priorité: 01.06.2001 FR 0107228; 20.07.2001 FR 0109729
(43) Date de publication de la demande: 17.03.2004
(73) Titulaire: Xenocs, 38360 Sassenage (FR)
(72) Inventeur: HOGHOJ, Peter, F-38950 Saint Martin le Vinoux (FR)
(74) Mandataire: Le Forestier, Eric
(86) Numéro de dépôt international: PCT/FR2002/001831
(87) Numéro de publication internationale: WO 2002/097486

(56) Documents cités:
- EP-A- 0 534 535
- WO-A-01/39211
- DE-A- 4 407 278
- DE-A- 10 001 291
- FR-A- 2 760 889
- US-A- 4 798 446
- US-A- 5 799 056
- US-A- 6 041 099
- PATENT ABSTRACTS OF JAPAN vol. 1998, no. 08, 30 juin 1998 (1998-06-30) & JP 10 073698 A (NIPPON TELEGR &TELEPH CORP <NTT>), 17 mars 1998 (1998-03-17) cité dans la demande

## Description

La présente invention concerne de manière générale les ensembles optiques réflectifs multicouches destinés à réfléchir des rayons X sous faible angle d'incidence.

On précise que par « faible angle d'incidence » on entend des angles d'incidence inférieurs à une valeur de l'ordre de 10° (l'angle d'incidence étant défini par rapport à la surface réfléchissante).

Plus précisément, l'invention concerne un dispositif optique selon la revendication 1.

Selon un aspect particulier, l'invention concerne également un procédé de réalisation d'un tel dispositif optique.

Par « effet optique bidimensionnel » on entend un effet optique utilisant deux directions différentes de l'espace.

Il peut par exemple s'agir d'une focalisation ou d'une collimation d'un faisceau dont les rayons ne sont parallèles dans aucune direction de l'espace (faisceau conique divergent par exemple).

Des applications (non limitatives) de l'invention concernent la génération de rayons X, des applications analytiques des rayons X telles que la diffraction, la diffraction de cristaux, la cristallographie de protéines, l'analyse de textures, la diffraction de films minces, la mesure de contraintes, la réflectométrie, la fluorescence rayons X.

On connaît déjà des ensembles optiques du type mentionné ci-dessus.

Considérant par exemple les installations de génération de rayons X, on trouvera un exemple de cette application dans le document JP 10-073698 (NTT).

Ce document divulgue une installation de génération de rayons X dans laquelle un ensemble optique est formé par deux composants, qui fournissent chacun un effet optique respectif, selon deux directions respectives différentes.

Un premier composant de cet ensemble optique est un miroir 4, dont la surface parabolique permet de concentrer des rayons X vers une fente de sortie 5 du dispositif.

Ceci correspond à un premier effet optique, assuré par la forme du miroir 4.

Un deuxième composant optique de cet ensemble optique est une structure diffractive plane 3, située en amont du miroir 4.

Ce deuxième composant permet de diffracter les rayons X générés par des impacts sur une cible 1, ceci correspondant à un deuxième effet optique.

Et l'ensemble optique formé de la structure 3 et du miroir 4 permet ainsi de combiner deux effets optiques, qui sont réalisés selon deux directions différentes.

Il en résulte un effet optique bidimensionnel en l'occurrence une focalisation sur un point d'un faisceau volumique issu de la cible 1).

Mais un inconvénient lié à un tel ensemble optique tient au fait que les deux effets optiques sont associés individuellement à deux composants distincts, qu'il est nécessaire de positionner l'un par rapport à l'autre de manière extrêmement précise.

L'ensemble optique doit donc être réglé avec la plus grande précision, lors de son installation. Ceci correspond à une opération complexe et consommatrice de temps.

En outre, les positions respectives de ces deux composants sont susceptibles de varier dans le temps, ce qui aurait pour effet de dégrader les performances de l'ensemble optique.

Une solution alternative pour obtenir un effet optique bidimensionnel serait de constituer un ensemble optique ne comportant qu'un composant sous la forme d'un miroir non cylindrique (dont la surface serait conformée selon une géométrie complexe, par exemple une paraboloïde ou un ellipsoïde).

Mais de tels miroirs aux formes complexes sont chers et difficiles à réaliser.

Et un autre inconvénient lié aux ensembles optiques du type de celui du document JP 10-073698 est que les rayons X doivent être réfléchis sur deux surfaces différentes (les surfaces respectives des deux composants), pour que les deux effets optiques s'exercent sur eux.

Il en résulte une atténuation des rayons traversant l'ensemble optique.

En outre, un tel ensemble optique doit nécessairement avoir une dimension longitudinale assez importante selon la direction générale de propagation des rayons, pour permettre aux rayons d'être réfléchis par les deux composants l'un après l'autre.

Et certains rayons peuvent en outre n'être réfléchis que par un des deux composants, et correspondent ainsi à des rayons parasites. L'élimination de ces rayons parasites nécessite la mise en oeuvre de moyens complémentaires qui complexifient encore un tel ensemble optique.

On connaît encore d'autres exemples de dispositif comportant deux éléments optiques réfléchissants et dont les deux réflexions combinées permettent de produire un effet optique bidimensionnel. On pourra à cet égard se référer aux documents US 4 798 446 (voir notamment figure 4), et US 6 041 099.

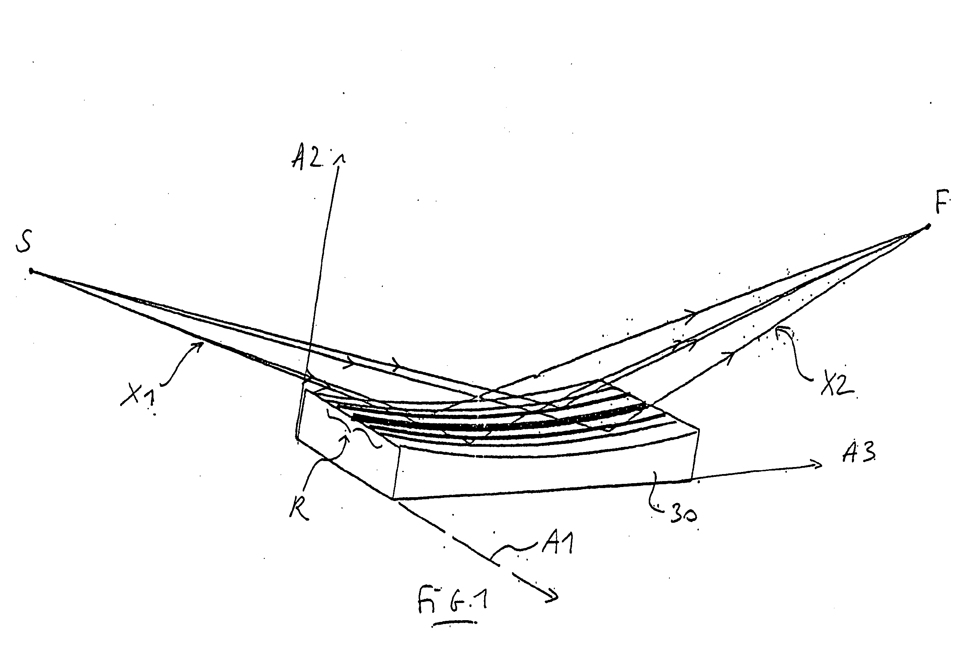

Enfin, on connaît par le document US 5 214 685 un dispositif permettant de focaliser un faisceau divergent sur un ligne de focalisation (voir notamment figure 1).

Un premier but de l'invention est de permettre de réaliser des ensembles optiques réflectifs multicouches du type cité en tout début de ce texte, sans être exposé aux inconvénients mentionnés ci-dessus.

Un deuxième but de l'invention est de permettre en outre d'ajuster de manière extrêmement précise différentes caractéristiques optiques d'un tel ensemble réflectif, cet ajustement de caractéristiques étant permanent et irréversible. Les caractéristiques à ajuster peuvent en particulier

comprendre les caractéristiques de déphasage et de réflectivité de l'ensemble optique.

On rappelle qu'on entend par « caractéristiques de déphasage » la propriété qui consiste à déphaser plus ou moins le rayonnement réfléchi par une structure réflective.

Et l'altération de la réflectivité et/ou du déphasage sont également des effets optiques, qui peuvent s'exercer selon une direction déterminée.

Afin d'atteindre les différents buts mentionnés ci-dessus, l'invention propose selon un premier aspect un dispositif optique selon la revendication 1. destiné à réfléchir des rayons X sous faible angle d'incidence en produisant

Des aspects préférés, mais non limitatifs du dispositif optique selon l'invention sont les suivants :
- la surface réfléchissante est conformée selon l'une des géométries suivantes :

- cylindrique, avec un cylindre pouvant par exemple avoir une directrice :
   ➢ circulaire, ou
   ➢ parabolique, ou
   ➢ elliptique,
- le multicouche est à gradient latéral,
- lesdits moyens permettant de produire un deuxième effet optique comprennent un motif diffractif,
- la surface réfléchissante est un cylindre et le motif diffractif comprend des raies diffractives agencées perpendiculairement à l'axe de ce cylindre,
- ledit motif diffractif est réalisé en relief sur le multicouche, ou gravé dans la structure du multicouche,
- lesdits moyens permettant de produire un deuxième effet optique comprennent en outre un motif réfractif,
- ledit motif réfractif est un motif de type lentille Kino,
- ledit motif réfractif est réalisé en relief sur le multicouche ou gravé dans la structure du multicouche,
- ledit premier effet optique monodimensionnel et ledit deuxième effet optique monodimensionnel sont chacun :
   - une collimation selon deux directions respectives, ou
   - une focalisation selon deux directions respectives.

Selon un deuxième aspect, l'invention propose également un procédé de fabrication d'un tel dispositif optique.

Des aspects préférés, mais non limitatifs du procédé selon l'invention sont les suivants :
- Le procédé est réalisé selon l'enchaînement des étapes principales suivantes :
   - déposer un multicouche sur un substrat plan, puis conformer ce multicouche afin de lui donner la géométrie désirée pour la surface réfléchissante, et constituer enfin un motif sur le miroir multicouche courbe ainsi créé,
   - déposer le multicouche sur un substrat plan, créer dessus le motif puis conformer le tout à la géométrie désirée,
   - générer une surface conformée à la géométrie désirée, puis déposer dessus un multicouche et constituer sur le tout un motif,
   - générer une surface conformée à la géométrie désirée, puis constituer dessus un motif et déposer sur le tout un multicouche,
   - générer le motif en premier, directement sur un substrat plan de départ, puis procéder dans un ordre quelconque à la conformation de la surface et au dépôt d'un multicouche,
- le motif comprend un motif diffractif et le procédé comprend la création d'une structure diffractive par l'altération d'une structure multicouche suite à l'exposition de la structure à un faisceau (20) énergétique, le procédé comprenant le contrôle de l'exposition des régions désirées de la structure multicouche audit faisceau, de manière à déplacer de manière désirée dans le spectre de longueur d'onde la valeur du pic de réflectivité (A1) de chaque région de la structure,
- ledit contrôle d'exposition est effectué en adaptant le temps d'exposition de chaque région individuelle de la structure au faisceau,
- ledit contrôle d'exposition met en oeuvre une modification temporaire et contrôlée de l'énergie du faisceau,
- le motif comprend un motif réfractif et le procédé comprend la gravure d'une résine ou d'un élément léger pour créer le motif réfractif.

D'autres aspects, buts et avantages de l'invention apparaîtront mieux à la lecture de la description suivante d'une forme de réalisation de l'invention, faite en référence aux dessins annexés sur lesquels :
- la figure 1 représente schématiquement un miroir multicouche qui correspond à un premier mode principal de réalisation d'un ensemble optique selon l'invention,
- la figure 2 est une représentation schématique d'une l'installation permettant de réaliser des ensembles optiques selon l'invention, selon un mode de réalisation préféré,
- les figures 3 et 4 sont des graphes détaillant certaines informations relatives au mode de réalisation préféré correspondant à l'installation de la figure 2 - la figure 3 étant un graphe montrant l'évolution de la position du pic de réflectivité d'une structure multicouche après avoir été soumise à un faisceau énergétique, et la figure 4 étant un graphe montrant les caractéristiques de réflectivité d'une structure réflective multicouche, et de phase du rayonnement réfléchi par une telle structure,
- la figure 5 représente schématiquement un miroir multicouche qui correspond à un deuxième mode principal de réalisation d'un ensemble optique selon l'invention.

En référence à la figure 1, on a représenté un miroir multicouche courbe 30 pour rayons X qui constitue un ensemble optique selon l'invention.

Ce miroir est destiné à réfléchir des rayons X sous faible angle d'incidence, comme tous les ensembles optiques dont il est question dans le présent texte.

Et ce miroir, comme les miroirs des ensembles optiques dont il est question dans le présent texte, est en outre un multicouche dont la structure de couche est adaptée pour que la condition de Bragg soit respectée en tout point de la surface utile du miroir.

On appellera dans ce texte par convention de tels miroirs des « miroirs à gradient latéral ».

On précise que le multicouche des différents modes de réalisation de l'invention peut également présenter un gradient en profondeur.

On rappelle que la condition de Bragg est de la forme nλ = 2d*sinθ, avec:
n : ordre de la réflexion,
λ : longueur d'onde de la radiation incidente,
d : période du multicouche,
θ : angle d'incidence sur la surface du multicouche.

Ainsi, pour un rayonnement de rayons X incidents selon une bande étroite de longueur d'onde telle que par exemple la raie Cuivre Kα (centrée autour d'une longueur d'onde de 0.15405 nanomètres), le miroir multicouche à gradient latéral permet de maintenir les conditions de Bragg sur l'ensemble de la surface utile du miroir.

Ceci conduit à la réflexion de la bande de longueur d'onde prédéterminée (dans l'exemple ci-dessus la raie Cuivre Kα), par différentes régions du miroir sur lesquelles les rayons incidents présentent des angles d'incidence locaux variables.

On peut ainsi augmenter la surface du miroir qui est effectivement utilisée.

Le gradient est obtenu en faisant varier la période du multicouche localement, de manière adaptée.

Comme cela est bien connu, ce type de structure multicouche à gradient permet d'augmenter l'angle solide de collection de l'optique ce qui conduit à un flux réfléchi plus élevé par rapport à des miroirs monocouches fonctionnant en réflexion totale, pour une géométrie d'optique identique.

La surface du miroir 30 est courbe, l'épaisseur du multicouche étant variable.

Ce miroir multicouche a pour support un substrat.

La direction A1 est fixe sur l'exemple de la figure 1.

La direction A3 varie quant à elle en fonction de l'endroit de la surface du miroir que l'on considère, et n'est représentée que pour un de ces endroits : il s'agit de la direction définissant avec la direction A1 le plan tangent local à la géométrie générale de la surface du miroir.

Cette surface du miroir définit une portion cylindrique, l'axe du cylindre étant parallèle à une direction représentée sur la figure par l'axe A1.

De la sorte, le miroir effectue une focalisation des rayons X incidents (notés X1) issus d'une source S, selon une direction A2 perpendiculaire aux directions de l'axe A1 et de l'axe A3.

La direction A2 change donc également en fonction de l'endroit de la surface du miroir que l'on considère : il s'agit de la direction normale locale à la surface du miroir (direction normale au plan tangent local).

Le miroir 30 a en outre été traité pour constituer sur sa surface réfléchissante un réseau de régions R qui demeurent réfléchissantes pour les rayons X incidents, mais qui induisent un décalage de phase de leur rayonnement réfléchi X2.

On reviendra plus loin dans ce texte sur un mode particulier de réalisation de l'invention permettant de constituer de telles régions R.

Ces régions ont chacune la forme d'une bande allongée, toutes les régions s'étendant parallèlement selon la direction générale A3 qui est perpendiculaire à la direction A1.

Les changements de phase générés par ces régions R induisent des interférences, qui correspondent à un phénomène de diffraction.

Et cette diffraction provoque une deuxième focalisation des rayons X1 - cette deuxième focalisation se faisant selon la direction A1 - de sorte que les rayons X2 réfléchis sont focalisés selon deux directions perpendiculaires sur un point désiré.

Le miroir 30 provoque ainsi un effet optique bidimensionnel: première focalisation selon la direction A2 et due à la géométrie générale de la surface du miroir, et deuxième focalisation selon la direction A1 et due à la diffraction générée par les régions R.

Ce miroir 30 constitue ainsi une forme de réalisation de l'invention, qui permet de focaliser les rayons issus de la source S sur un foyer F.

On remarquera que par rapport à des ensembles optiques comprenant différents composants dédiés chacun à un effet optique, l'invention permet de s'affranchir des inconvénients mentionnés en introduction du présent texte.

En particulier, aucun réglage ou ajustement de la position de différents composants n'est nécessaire, le miroir 30 ne comportant qu'un composant unique qui assure deux effets optiques (ici deux focalisations selon deux directions différentes).

Il est ainsi possible de former un ensemble optique sous la forme d'un miroir multicouche dont la surface réfléchissante est conformée pour assurer un premier effet optique selon une première direction de l'espace (effet de focalisation ou de collimation dans une direction, par exemple), avec des moyens portés par cette même surface pour assurer un deuxième effet optique selon une deuxième direction de l'espace, différente de la première direction.

Et ces moyens peuvent être, dans un premier mode principal de réalisation de l'invention, une structure diffractive, qui peut présenter un motif diffractant désiré.

Comme on le verra, ces moyens peuvent être dans un deuxième mode principal de réalisation de l'invention, une structure réfractive, qui peut présenter un motif réfractif désiré

Revenant au premier mode principal de réalisation de l'invention, une telle structure diffractive peut être une structure fonctionnant dans l'espace des amplitudes, et/ou dans l'espace des phases.

Une telle structure diffractive peut être générée à la surface du miroir de l'ensemble optique par une technique de lithographie.

On reviendra dans la suite de ce texte sur un exemple de procédé permettant de créer de telles structures.

La surface du miroir a une forme qui est destinée à générer un effet optique monodimensionnel, dans une première direction de l'espace.

Cet effet optique peut être en particulier une focalisation monodirectionnelle ou une collimation monodirectionnelle, selon une première direction de l'espace.

Et de même, le deuxième effet optique généré par les moyens portés par la surface du miroir peut correspondre à une focalisation monodirectionnelle ou une collimation monodirectionnelle, selon une deuxième direction de l'espace différente de la première direction.

Les deux effets optiques se combinent ainsi pour produire un effet optique bidimensionnel, tel qu'une focalisation bidimensionnelle sur un point image (combinaison de deux focalisations monodimensionnelles), ou une collimation d'un faisceau incident divergent en un faisceau parallèle selon toutes les directions de l'espace.

La forme du miroir a une géométrie simple, facile et peu onéreuse à réaliser.

Cette forme peut être en particulier réalisée selon l'une des géométries suivantes :
- cylindrique, avec un cylindre pouvant par exemple avoir une directrice :
   ➢ circulaire, ou
   ➢ parabolique, ou
   ➢ elliptique,
- sphérique.

Dans le cas d'un miroir cylindrique, on pourra agencer les raies de la structure diffractive sur la surface conformée du miroir, perpendiculairement à l'axe du cylindre (comme cela est illustré sur la figure 1).

Un autre avantage lié à l'invention est que les rayons X ne subissent qu'une seule réflexion sur l'ensemble optique. De ce fait, les inconvénients mentionnés en introduction à propos des configurations connues à deux surfaces réflectives sont supprimés.

Concernant maintenant la fabrication d'un ensemble optique selon l'invention, plusieurs manières sont envisageables pour constituer un tel ensemble.

Il est possible en particulier de procéder selon une des manières générales suivantes :
- déposer un multicouche sur un substrat plan, puis conformer ce multicouche afin de lui donner la géométrie désirée pour la surface réfléchissante, et constituer enfin un motif (diffractif ou réfractif - on désignera ces moyens par le terme général de « motif ») sur le miroir multicouche courbe ainsi créé. Dans ce cas (comme dans les autres cas), on pourra ajuster l'épaisseur du multicouche après sa conformation à la géométrie désirée, et réaliser les gradients de période nécessaires au respect de la condition de Bragg,
- déposer le multicouche sur un substrat plan, créer dessus le motif puis conformer le tout à la géométrie désirée,
- générer une surface conformée à la géométrie désirée, puis déposer dessus un multicouche et constituer sur le tout un motif,
- générer une surface conformée à la géométrie désirée, puis constituer dessus un motif et déposer sur le tout un multicouche,
- il est même possible de générer le motif en premier, directement sur un substrat plan de départ (par exemple par gravure du substrat), puis de procéder dans un ordre quelconque à la conformation de la surface et au dépôt d'un multicouche.

Concernant plus particulièrement la constitution d'un motif diffractant qui correspond à un premier mode principal de réalisation de l'invention, on va maintenant décrire une technique particulière de fabrication d'un tel motif qui permet d'ajuster simultanément différentes caractéristiques de l'ensemble optique (en particulier le comportement en phase et en amplitude).

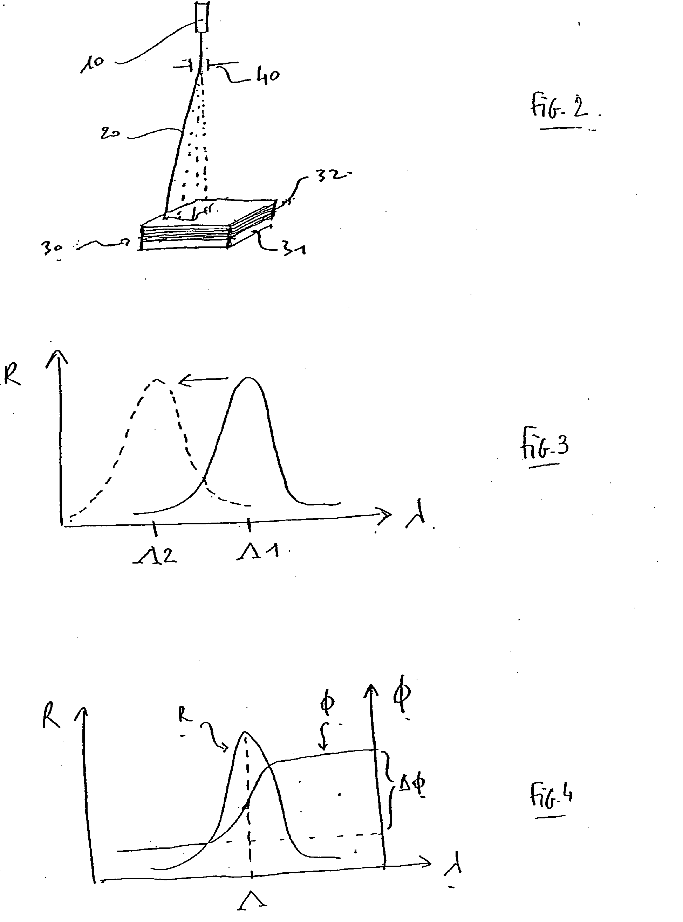

En référence à la figure 2, on a représenté de manière schématique une installation permettant de mettre en oeuvre ce mode préféré de réalisation.

Cette installation est destinée à créer sur un multicouche une structure diffractive selon un motif désiré.

On précise qu'on référencera 30 indifféremment dans le présent texte un multicouche à ses différents stades d'élaboration (multicouche seulement, multicouche fini correspondant à l'ensemble optique selon l'invention - par exemple ensemble 30 de la figure 1).

Cette installation comprend une source 10 qui est apte à émettre un faisceau énergétique 20.

Le faisceau énergétique 20 peut être un faisceau de particules. Dans ce cas, les particules du faisceau peuvent être par exemple des ions, mais également des électrons, des molécules, etc..

Le faisceau 20 peut également être un faisceau de rayonnement pur, par exemple un faisceau de photons, de rayons X, ...

La source 10 peut ainsi être de type connu en soi, par exemple une source d'électrons similaire à celles employées pour la gravure de la résine photosensible de masques pour lithographie.

Dans tous les cas, le faisceau 20 est un faisceau capable d'altérer la structure du multicouche 30 qui est exposé au faisceau 20 et de modifier l'épaisseur des couches de ce multicouche par son apport d'énergie.

On précise que l'apport d'énergie du faisceau au multicouche peut provenir directement de l'énergie du faisceau, dans le cas d'un faisceau énergétique.

Et il est également possible que cette énergie apportée au multicouche provienne d'une réaction suscitée par la rencontre du faisceau 20 et du multicouche 30.

Une telle réaction peut être par exemple une réaction chimique (cas d'un faisceau de particules d'oxygène qui viennent oxyder le multicouche), ou une réaction de type nucléaire.

Le multicouche 30 comprend un substrat 31, et un empilement 32 de couches alternées.

L'empilement 32 comporte une alternance de couches (par exemple de Mo et de Si) dont les propriétés optiques de réflectivité permettent de réfléchir le rayonnement d'une source de longueur d'onde donnée (non représentée sur la figure).

Et les propriétés spécifiques de réflectivité de l'empilement de couches 32 déterminent une plage de longueurs d'onde pour lesquelles le rayonnement sera effectivement réfléchi.

On comprend donc qu'une structure multicouche donnée peut réfléchir des rayonnements à l'intérieur d'une plage donnée de longueurs d'onde.

Plus précisément, exposée à un rayonnement incident d'amplitude et de longueur d'onde données, une structure multicouche réflective réfléchit un rayonnement dont l'amplitude varie en fonction de la longueur d'onde du rayonnement incident.

Ce principe, qui est exploité dans l'invention, est illustré sur le graphe de la figure 3.

Ce graphe représente l'évolution pour une structure réflective multicouche, du coefficient de réflectivité R (qui traduit la proportion d'énergie lumineuse renvoyée par le rayonnement réfléchi), en fonction de la longueur d'onde λ du rayonnement incident.

On constate qu'il existe une longueur d'onde Λ1 pour laquelle la réflectivité de la structure est maximale, et que cette longueur d'onde A correspond à un pic de réflectivité bien marqué.

Ainsi, chaque structure réflective est associée à un pic de réflectivité qui est déterminé par une longueur d'onde donnée : la structure réfléchit mieux les rayonnements dont la longueur d'onde est égale à, ou très proche de, cette longueur d'onde Λ1 (qui est représentée par un paramètre de "période", A1 étant égal, ou étroitement lié, à la période).

On précise que les propriétés de réflectivité de la structure 30 sont elles-mêmes déterminées d'une part par la nature des matériaux mis en oeuvre dans l'empilement 32, et d'autre part par l'épaisseur des couches de cet empilement.

Des moyens 40 d'orientation contrôlée du faisceau permettent d'orienter ledit faisceau vers des régions désirées de la structure 30, et de déplacer le faisceau sur la structure selon un motif prédéterminé.

De la sorte, on altère des régions désirées de la structure par suite de l'interaction du faisceau énergétique 20 et des couches de l'empilement 32.

On remarquera qu'on ne détruit pas avec cette technique la structure multicouche.

En effet, l'exposition de la structure 30 est contrôlée de manière à ce que la région de la structure exposée au faisceau 20 ne soit pas détruite, mais que l'épaisseur des couches de l'empilement soit simplement modifiée de manière à changer de manière désirée la période de cet empilement.

On déplace ainsi de manière contrôlée le pic de réflectivité de la région de la structure exposée, dans le spectre de longueurs d'onde.

En effet, la Demanderesse a observé qu'une exposition limitée et contrôlée d'une structure multicouche telle que décrite ci-dessus aboutissait à un tel déplacement du pic de réflectivité de ladite région.

En d'autres termes, on ne supprime pas la réflectivité, mais on la déplace dans le spectre de longueurs d'onde.

On ne rend ainsi pas des régions « absorbantes » dans l'absolu, on les rend absorbantes pour une gamme de longueurs d'onde donnée, les propriétés de réflectivité de ces régions demeurant pour d'autres longueurs d'onde.

Ce principe est exposé sur le graphe de la figure 3, qui montre le pic de réflectivité situé en A1 d'une région de la structure avant son exposition au faisceau 20, et le pic de réflectivité situé en A2 et correspondant à la même région après son exposition audit faisceau.

Et les propriétés réflectives des régions de la structure 30 qui sont exposées de manière contrôlée au faisceau 20 sont ainsi altérées de manière désirée (et permanente), de sorte que ces régions sont après exposition encore capables de réfléchir un rayonnement avec une intensité comparable du rayonnement réfléchi, mais uniquement dans la mesure où le rayonnement incident a une longueur d'onde qui correspond au nouveau pic de réflectivité de la région traitée.

Ce déplacement du pic de réflectivité est en outre lui-même contrôlé, dans la mesure où on adapte l'exposition de manière à amener le pic de réflectivité de la région exposée à une valeur désirée, différente de la valeur du pic de réflectivité des régions de la structure qui ne sont pas exposées au faisceau 20.

Le contrôle de l'exposition peut se faire en adaptant le temps d'exposition de chaque région individuelle de la structure au faisceau 20.

Le contrôle d'exposition peut également mettre en oeuvre une modification temporaire et contrôlée de l'énergie du faisceau 20.

Il est ainsi possible de traiter toute région désirée de la structure 30, pour décaler de manière contrôlée le pic de réflectivité de la région.

Partant d'une structure telle qu'un miroir multicouche dont la structure multicouche permet de réfléchir des rayons X, il est ainsi possible selon l'invention de traiter certaines régions du miroir pour déplacer leur pic de réflectivité de manière à ce que lesdites régions ne réfléchissent pas les rayons X.

On constitue de la sorte un masque réflectif aux rayons X.

Et on comprend qu'il est possible de la sorte de traiter des régions désirées d'une structure réfléchissante, en fonction de la longueur d'onde de la source de rayonnement avec laquelle la structure est destinée à coopérer une fois traitée.

En effet, on traitera alors des régions spécifiques de cette structure pour les rendre non réfléchissantes vis à vis du rayonnement spécifique de cette source (en l'occurrence une source de rayons X).

II est possible de traiter de la sorte une structure en « négatif », en traitant certaines régions de manière à déplacer leur pic de réflectivité en vue de les rendre non réfléchissantes pour une source de rayonnement de longueur d'onde donnée, alors que les régions non traitées de la structure ont intrinsèquement un pic de réflectivité correspondant à la longueur d'onde de cette source et seront donc réfléchissantes pour son rayonnement.

Il est également possible de traiter des régions de la structure en « positif », en provoquant le déplacement de leur pic de réflectivité de manière à ce qu'il corresponde au contraire à la longueur d'onde d'une source de rayonnement et que les régions traitées soient donc rendues réflectives pour cette source, alors que la structure avait à l'origine une période qui ne correspondait pas à la longueur d'onde de la source de sorte qu'elle ne réfléchissait pas son rayonnement.

Selon une variante avantageuse, il est possible de définir sur la surface de la structure à traiter des régions que l'on souhaite traiter différemment, non seulement en les rendant sélectivement réflectives ou non réflectives pour une longueur d'onde donnée (et donc toujours en l'occurrence une source de rayons X), mais en dégradant en outre de manière contrôlée les propriétés de réflectivité de ces régions vis à vis d'une longueur d'onde donnée.

On peut ainsi constituer sur la structure des régions dont la réponse lumineuse réfléchie à un rayonnement de longueur d'onde donnée est plus ou moins importante, en définissant avec finesse le changement de période (et donc le décalage du pic de réflectivité) de chaque région.

Il est ainsi possible de constituer des structures dont la réponse en réflexion à un rayonnement de longueur d'onde donnée est de nature « analogique », les différentes régions ayant des pics de réflectivité décalés différemment de manière à rester réflectives pour le rayonnement de la source, mais avec des coefficients de réflectivité différents - on construit de la sorte une structure dont les différentes régions réfléchissent en « niveaux de gris » différents.

Et il est également possible de contrôler selon l'invention la répartition spatiale de phase du rayonnement réfléchi par les différentes régions de la structure 30.

En effet, le rayonnement réfléchi par la région de la structure peut être décrit par la formule A.e^{i(κλ+Φ)}.

Et comme illustré sur la figure 4, la période A associée à une région de la structure multicouche ne définit pas seulement un maximum de réflectivité, mais également une région de changement pour la phase Φ de ce rayonnement réfléchi.

Plus précisément, on observe un déphasage ΔΦ de l'ordre de 180 degrés de part et d'autre de la longueur d'onde A correspondant à la période de la région en question.

En modifiant de manière désirée la période de ladite région par exposition contrôlée au faisceau 20, on modifie donc également les caractéristiques de phase du rayonnement réfléchi.

Et on peut donc « dessiner » sur la structure 30 des régions dont le rayonnement réfléchi sous exposition à une source de longueur d'onde déterminée présente un déphasage désiré.

Un tel contrôle est en particulier intéressant dans la mesure où il permet, à partir d'une telle structure, d'obtenir une image avec un contraste amélioré.

La réalisation d'un ensemble optique comprenant un miroir multicouche réfléchissant les rayons X, conformé pour produire un premier effet optique, et portant un motif diffractif produisant un deuxième effet optique, n'est pas limitée à la technique particulière qui vient d'être décrite.

Il est en effet possible de créer de tels motifs par toute autre technique, qui serait connue en soi.

On peut ainsi réaliser le motif diffractif en relief par gravure d'une résine ou d'une couche d'un élément léger ou d'un composite d'élément léger (de manière à ce que les rayons X ne subissent pas une atténuation importante en traversant cet élément), ou encore réaliser le motif par gravure du multicouche (par une technique de lithographie).

Les éléments légers mentionnés ci-dessus sont ceux du tableau périodique des éléments ayant un numéro atomique Z inférieure à 15.

On peut par exemple utiliser l'effet de diffraction d'un réseau de zones de Fresnel, gravées sur le multicouche avec une géométrie qui permet de les utiliser en réflexion.

De telles structures dites lentilles multicouches de Bragg-Fresnel sont connues et on adaptera les schémas des lentilles ainsi constituées pour générer avec le motif diffractif correspondant à ces lentilles multicouches de Bragg-Fresnel l'effet optique monodimensionnel désiré (par exemple une focalisation monodimensionnelle dans une seule direction de l'espace).

Comme on l'a dit, il est également possible de réaliser l'invention selon un deuxième mode principal de réalisation, dans lequel le motif porté par la surface du miroir multicouche à gradient latéral est un motif réfractif.

Dans ce cas, on combine l'effet de réfraction associé au motif à la réflexion associée au miroir 40 lui-même.

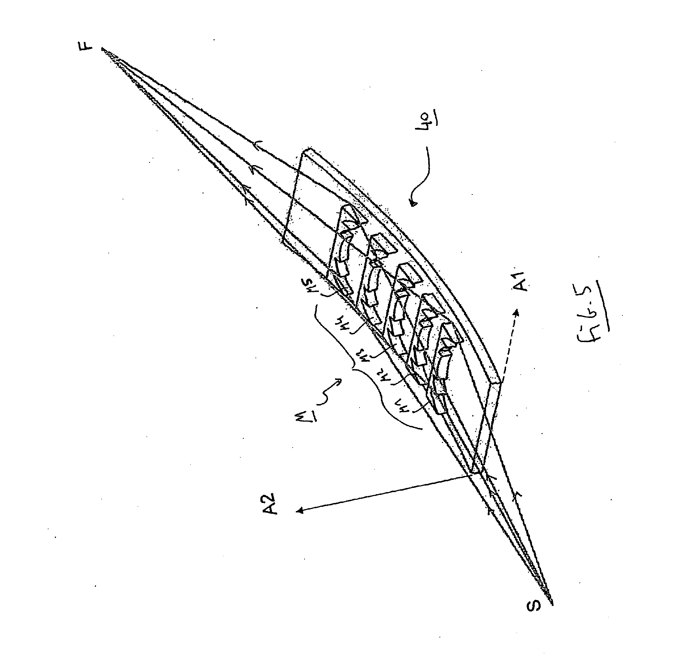

Le motif réfractif réalisé peut être un motif de type lentille Kino (comme représenté sur la figure 5), réalisé en relief sur le multicouche ou encore gravé dans la structure du multicouche.

Dans le cas d'une structure en relief, on pourra en particulier créer le motif réfractif par gravure d'une résine ou d'un élément léger (tel que par exemple l'aluminium, le béryllium, le bore ou le graphite - pour réduire l'absorption aux rayons X) qui recouvre la surface du multicouche.

Une telle gravure peut être conduite en utilisant des techniques de lithographie.

On mettra ainsi en oeuvre avec profit des technologies de fabrications de microélectronique planaires (lithographie et gravure par plasma) qui présentent l'avantage de permettre de contrôler très finement la géométrie du motif réfractif.

On précise cependant qu'il est également possible de réaliser le motif réfractif par tout autre type de technique.

Revenant à la figure 5, on a donc représenté un miroir multicouche 40, qui comme le miroir 30 de la figure 1 est à gradient latéral.

Les axes A1, A2 et A3 de la figure 1 se retrouvent ici et sont définis de la même manière.

Le miroir 40 définit ici encore une portion cylindrique, l'axe du cylindre étant parallèle à une direction représentée par un axe A1.

De la sorte, le miroir effectue une focalisation des rayons X incidents selon la direction A2.

Et ici encore, la forme générale de la surface du miroir peut être adaptée pour produire tout effet optique monodimensionnel désiré, comme dans le cas du miroir 30 de la figure 1.

La surface du miroir 40 porte un motif réfractif M.

Ce motif M est constitué de zones réfractives M1 à M5 qui assurent une focalisation monodimensionnelle selon une direction parallèle à la direction A1.

Il est à noter que le schéma représenté est simplifié dans la mesure où il est possible de disposer un nombre beaucoup plus important de zones réfractives afin d'obtenir de courtes distances focales pouvant satisfaire au domaine d'application de l'invention (par exemple des distances focales inférieures à 1 mètre).

Il est ainsi possible par exemple de réaliser un assemblage en série de quelques dizaines de zones réfractives ayant des dimensions de quelques dizaines de micromètres en mettant à profit les technologies de microélectronique planaires mentionnées ci-dessus.

Dans ce deuxième mode principal de réalisation de l'invention, comme dans le premier, on obtient donc une combinaison sur un même composant optique de deux effets optiques monodimensionnels réalisés selon deux direction différentes de l'espace, pour générer un effet optique bidimensionnel.

On précise qu'ici encore, la géométrie de la surface du miroir 40 peut être adaptée pour générer tout effet monodimensionnel - en particulier une focalisation ou une collimation.

Et il en est de même pour le motif réfractif M.

On précise enfin que les deux modes principaux de réalisation de l'invention mentionnés ci-dessus (motif diffractif et motif réfractif) peuvent être combinés, dans un ensemble optique dont la surface réflective conformée pour produire un premier effet optique porte un motif diffractif et réfractif à la fois.

## Revendications

1. Dispositif optique comprenant une source (S) de rayons X et un ensemble optique réflectif multicouche (30) destiné à réfléchir des rayons X issus de ladite source (S), lesdits rayons X arrivant audit ensemble optique sous faible angle d'incidence par rapport à une surface réfléchissante dudit ensemble optique en produisant un effet optique bidimensionnel, **caractérisé en ce que** l'ensemble optique comporte :
• un composant (30) présentant ladite surface réfléchissante, la surface réfléchissante étant conformée selon une géométrie cylindrique de manière à produire un premier effet optique monodimensionnel selon une première direction (A2) de l'espace, ledit premier effet optique monodimensionnel étant une focalisation ou une collimation et
• des moyens permettant de produire un deuxième effet optique monodimensionnel selon une deuxième direction (A1) de l'espace, différente de la première direction, lesdits moyens (R) permettant de produire un deuxième effet optique étant un motif diffractif porté par ladite surface réfléchissante, ledit motif diffractif comprenant des raies diffractives s'étendant perpendiculairement à l'axe du cylindre, ledit deuxième effet optique monodimensionnel étant une focalisation ou une collimation,
ledit ensemble optique (30) étant agencé de sorte que la direction générale de propagation des rayons X issus de la source (S) soit orthogonale à l'axe du cylindre, pour produire un effet optique bidimensionnel en faisant subir aux rayons X une réflexion unique, ledit effet optique bidimensionnel résultant de la combinaison desdits premier et deuxième effets optiques monodimensionnels..

2. Dispositif optique selon la revendication précédente, **caractérisé en ce que** la surface réfléchissante est conformée selon une géométrie cylindrique, avec un cylindre ayant une directrice :
➢ circulaire, ou
➢ parabolique, ou
➢ elliptique.

3. Dispositif optique selon l'une des revendications précédentes, **caractérisé en ce que** le multicouche est à gradient latéral.

4. Dispositif optique selon l'une des revendications précédentes, **caractérisé en ce que** ledit motif diffractif est réalisé en relief sur le multicouche, ou gravé dans la structure du multicouche.

5. Dispositif optique selon l'une des revendications précédentes, **caractérisé en ce que** lesdits moyens permettant de produire un deuxième effet optique comprennent en outre un motif réfractif.

6. Dispositif optique selon la revendication précédente, **caractérisé en ce que** ledit motif réfractif est un motif de type lentille Kino.

7. Dispositif optique selon la revendication précédente, **caractérisé en ce que** ledit motif réfractif est réalisé en relief sur le multicouche ou gravé dans la structure du multicouche.

8. Dispositif optique selon l'une des revendications précédentes, **caractérisé en ce que** ledit premier effet optique monodimensionnel et ledit deuxième effet optique monodimensionnel sont chacun :
• une collimation selon deux directions respectives, ou
• une focalisation selon deux directions respectives.

9. Procédé de fabrication d'un dispositif optique selon l'une des revendications précédentes, **caractérisé en ce que** le procédé est réalisé selon l'un des enchaînements des étapes principales suivantes :
• déposer un multicouche sur un substrat plan, puis conformer ce multicouche afin de lui donner la géométrie désirée pour la surface réfléchissante, et constituer enfin un motif sur le miroir multicouche courbe ainsi créé,
• déposer le multicouche sur un substrat plan, créer dessus le motif puis conformer le tout à la géométrie désirée,
• générer une surface conformée à la géométrie désirée, puis déposer dessus un multicouche et constituer sur le tout un motif,
• générer une surface conformée à la géométrie désirée, puis constituer dessus un motif et déposer sur le tout un multicouche,
• générer le motif en premier, directement sur un substrat plan de départ, puis procéder dans un ordre quelconque à la conformation de la surface et au dépôt d'un multicouche

10. Procédé selon la revendication précédente, **caractérisé en ce que** le motif comprend un motif diffractif et le procédé comprend la création d'une structure diffractive par l'altération d'une structure multicouche suite à l'exposition de la structure à un faisceau (20) énergétique, le procédé comprenant le contrôle de l'exposition des régions désirées de la structure multicouche audit faisceau, de manière à déplacer de manière désirée dans le spectre de longueur d'onde la valeur du pic de réflectivité (A1) de chaque région de la structure.

11. Procédé selon la revendication précédente, **caractérisé en ce que** ledit contrôle d'exposition est effectué en adaptant le temps d'exposition de chaque région individuelle de la structure au faisceau.

12. Procédé selon l'une des deux revendications précédentes, **caractérisé en ce que** ledit contrôle d'exposition met en oeuvre une modification temporaire et contrôlée de l'énergie du faisceau.

13. Procédé selon la revendication 9, **caractérisé en ce que** le motif comprend un motif réfractif et le procédé comprend la gravure d'une résine ou d'un élément léger pour créer le motif réfractif.

## Claims

1. Optical device comprising a source (S) of X-rays and a multilayer reflective optical assembly (30) intended to reflect X-rays emanating from said source (S), said X-rays arriving at said optical assembly at a low angle of incidence with respect to a reflecting surface of said optical assembly while producing a two-dimensional optical effect, **characterized in that** the optical assembly comprises:
• a component (30) having said reflecting surface, the reflecting surface being shaped according to a cylindrical geometry in such a way as to produce a first one-dimensional optical effect along a first direction (A2) in space, said first one-dimensional optical effect being a focusing or a collimation and
• means for producing a second one-dimensional optical effect in a second direction (A1) in space, different from the first direction, said means (R) for producing a second optical effect being a diffractive pattern carried by said reflecting surface, said diffractive pattern comprising diffractive lines extending perpendicularly to the axis of the cylinder, said second one-dimensional optical effect being a focusing or a collimation,
said optical assembly (30) being arranged so that the general direction of propagation of the X-rays emanating from the source (S) is orthogonal to the axis of the cylinder, so as to produce a two-dimensional optical effect by making the X-rays undergo a single reflection, said two-dimensional optical effect resulting from combining said first and second one-dimensional optical effects.

2. Optical device according to the preceding claim, **characterized in that** the reflecting surface is shaped according to a cylindrical geometry with a cylinder having:
➢ a circular directrix or
➢ a parabolic directrix or
➢ an elliptical directrix.

3. Optical device according to either of the preceding claims, **characterized in that** the multilayer is a laterally-graded multilayer.

4. Optical device according to one of the preceding claims, **characterized in that** said diffractive pattern is produced in relief on the multilayer, or etched into the structure of the multilayer.

5. Optical device according to one of the preceding claims, **characterized in that** said means for producing a second optical effect further comprise a refractive pattern.

6. Optical device according to the preceding claim, **characterized in that** said refractive pattern is a pattern of the Kino lens type.

7. Optical device according to the preceding claim, **characterized in that** said refractive pattern is produced in relief on the multilayer or etched into the structure of the multilayer.

8. Optical device according to one of the preceding claims, **characterized in that** said first one-dimensional optical effect and said second one-dimensional optical effect are each:
• a collimation in two respective directions or
• a focusing in two respective directions.

9. Process for manufacturing an optical device according to one of the preceding claims, **characterized in that** the process is carried out according to one of the sequences of the following main steps:
• of depositing a multilayer on a planar substrate, then of shaping this multilayer so as to give it the desired geometry for the reflecting surface and, finally, of forming a pattern on the curved multilayer mirror thus created,
• of depositing the multilayer on a planar substrate, of creating the pattern on top and then of shaping the combination to the desired geometry,
• of generating a shaped surface with the desired geometry, then of depositing a multilayer on top and of forming a pattern on the combination,
• of generating a shaped surface with the desired geometry, then of forming a pattern on top and of depositing a multilayer on the combination,
• of generating the pattern first, directly on an initial planar substrate, and then of carrying out, in either order, the shaping of the surface and the deposition of a multilayer.

10. Process according to the preceding claim, **characterized in that** the pattern comprises a diffractive pattern and the process comprises the creation of a diffractive structure through the alteration of a multilayer structure following the exposure of the structure to an energy beam (20), the process comprising the control of the exposure of the desired regions of the multilayer structure to said beam, so as to shift the value of the reflectivity peak (A1) of each region of the structure in the desired manner within the wavelength spectrum.

11. Process according to the preceding claim, **characterized in that** said exposure control is performed by adapting the duration of exposure of each individual region of the structure to the beam.

12. Process according to either of the two preceding claims, **characterized in that** said exposure control involves a temporary and controlled modification of the energy of the beam.

13. Process according to Claim 9, **characterized in that** the pattern comprises a refractive pattern and the process comprises the etching of a resist or of a light element in order to create the refractive pattern.

## Patentansprüche

1. Optische Vorrichtung folgendes umfassend: eine Quelle (S) für Röntgenstrahlen und eine optische reflektierende mehrschichtige Einheit (30), die dafür vorgesehen ist, Röntgenstrahlen zu reflektieren, die von der Quelle (S) kommen, wobei die Röntgenstrahlen an der optischen Einheit unter einem kleinen Einfallswinkel in Bezug auf eine reflektierende Oberfläche der optischen Einheit eintreffen, wobei sie einen zweidimensionalen optischen Effekt erzeugen, **dadurch gekennzeichnet, dass** die optische Einheit folgendes umfasst:
• eine Komponente (30), die die reflektierende Oberfläche aufweist, wobei die reflektierende Oberfläche mit einer zylindrischen Geometrie ausgestaltet ist, derart, dass sie einen ersten eindimensionalen optischen Effekt in einer ersten Richtung (A2) des Raumes erzeugt, wobei der erste eindimensionale optische Effekt eine Fokussierung oder eine Bündelung ist, und
• Mittel, um einen zweiten eindimensionalen optischen Effekt in einer zweiten Richtung (A1) des Raumes, die verschieden von der ersten Richtung ist, zu erzeugen, wobei die Mittel (R), um einen zweiten optischen Effekt zu erzeugen, ein beugendes Muster sind, das von der reflektierenden Oberfläche getragen wird, wobei das beugende Muster beugende Linien umfasst, die sich senkrecht zur Achse des Zylinders erstrecken und wobei der zweite eindimensionale optische Effekt eine Fokussierung oder eine Bündelung ist,
wobei die optische Einheit (30) dafür eingerichtet ist, dass die Hauptausbreitungsrichtung der von der Quelle (S) kommenden Röntgenstrahlen senkrecht zur Achse des Zylinders ist, um einen zweidimensionalen optischen Effekt zu erzeugen, wobei die Röntgenstrahlen eine einzige Reflektion erfahren und wobei der zweidimensionale optische Effekt sich aus der Kombination des ersten und des zweiten eindimensionalen optischen Effekts ergibt.

2. Vorrichtung nach dem vorhergehenden Anspruch, **dadurch gekennzeichnet, dass** die reflektierende Oberfläche mit einer zylindrischen Geometrie ausgestaltet ist, mit einem Zylinder, der eine der folgenden Leitkurven hat:
• kreisförmig, oder
• parabolisch, oder
• elliptisch.

3. Vorrichtung nach einem der vorhergehenden Ansprüche, **dadurch gekennzeichnet, dass** die Mehrschichtstruktur einen seitlichen Gradienten hat.

4. Vorrichtung nach einem der vorhergehenden Ansprüche, **dadurch gekennzeichnet, dass** das beugende Muster als Profil auf der Mehrschichtstruktur realisiert oder in die Struktur der Mehrschichtstruktur eingraviert ist.

5. Vorrichtung nach einem der vorhergehenden Ansprüche, **dadurch gekennzeichnet, dass** die Mittel, die es gestatten, einen zweiten optischen Effekt zu erzeugen, außerdem ein brechendes Muster umfassen.

6. Vorrichtung nach dem vorhergehenden Anspruch, **dadurch gekennzeichnet, dass** das brechende Muster ein Muster vom Typ einer Kinolinse ist.

7. Vorrichtung nach dem vorhergehenden Anspruch, **dadurch gekennzeichnet, dass** das brechende Muster als Profil auf der Mehrschichtstruktur realisiert oder in die Struktur der Mehrschichtstruktur eingraviert ist.

8. Vorrichtung nach einem der vorhergehenden Ansprüche, **dadurch gekennzeichnet, dass** der erste eindimensionale optische Effekt und der zweite eindimensionale optische Effekt jeweils
• eine Bündelung in zwei jeweiligen Richtungen, oder
• eine Fokussierung in zwei jeweiligen Richtungen sind.

9. Verfahren zur Herstellung einer optischen Vorrichtung nach einem der vorhergehenden Ansprüche, **dadurch gekennzeichnet, dass** das Verfahren gemäß einer der Aneinanderreihungen der folgenden Hauptschritte realisiert ist:
• Auftragen einer Mehrschichtstruktur auf ein ebenes Substrat, danach ein Anpassen dieser Mehrschichtstruktur, um ihr die gewünschte Geometrie für die reflektierende Oberfläche zu geben, und schließlich das Ausbilden eines Musters auf dem so erzeugten gekrümmten Mehrschichtspiegel,
• Auftragen der Mehrschichtstruktur auf ein ebenes Substrat, Erzeugen des Musters darauf, danach Anpassen des Ganzen an die gewünschte Geometrie,
• erzeugen einer Oberfläche, die an die gewünschte Geometrie angepasst ist, dann das Auftragen einer Mehrschichtstruktur darauf und das Ausbilden eines Musters auf dem Ganzen,
• erzeugen einer Oberfläche, die an die gewünschte Geometrie angepasst ist, dann das Ausbilden eines Musters darauf und Auftragen einer Mehrschichtstruktur auf das Ganze,
• zuerst das Erzeugen des Musters, direkt auf einem ebenen Ausgangssubstrat, dann in einer beliebigen Reihenfolge die Anpassung der Oberfläche und das Auftragen einer Mehrschichtstruktur.

10. Verfahren nach dem vorhergehenden Anspruch, **dadurch gekennzeichnet, dass** das Muster ein beugendes Muster umfasst und das Verfahren das Erzeugen einer beugenden Struktur durch die Veränderung einer Mehrschichtstruktur infolge der Bearbeitung der Struktur mit einem energetischen Strahl (20) umfasst, wobei das Verfahren die Steuerung der Bearbeitung von gewünschten Bereichen der Mehrschichtstruktur mit dem Strahl umfasst, derart, dass in gewünschter Weise im Wellenlängenspektrum der Spitzenwert des Reflexionsgrads (A1) jedes Bereichs der Struktur verschoben wird.

11. Verfahren nach dem vorhergehenden Anspruch, **dadurch gekennzeichnet, dass** die Steuerung der Bearbeitung durchgeführt wird, indem die Dauer der Bearbeitung von jedem einzelnen Bereich der Struktur durch den Strahl angepasst wird.

12. Verfahren nach einem der beiden vorhergehenden Ansprüche, **dadurch gekennzeichnet, dass** die Steuerung der Bearbeitung eine zeitlich begrenzte und gesteuerte Veränderung der Energie des Strahls verwendet.

13. Verfahren nach Anspruch 9, **dadurch gekennzeichnet, dass** das Muster ein brechendes Muster umfasst und das Verfahren das Gravieren eines Harzes oder eines leichten Elements zum Erzeugen des brechenden Musters umfasst.
